(19) Europäisches Patentamt
European Patent Office
Office européen des brevets

(11) **EP 2 256 762 A1**

(12) **EUROPEAN PATENT APPLICATION**

(43) Date of publication:
**01.12.2010 Bulletin 2010/48**

(51) Int Cl.:
*H01G 9/20* [(2006.01)]     *H01L 51/44* [(2006.01)]

(21) Application number: **09161215.0**

(22) Date of filing: **27.05.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **Honeywell International Inc.**
**Morristown, NJ 07962 (US)**

(72) Inventors:
• **Mihaila, Mihai N**
  **RO 023555, Bucharest (RO)**

• **Serban, Bogdan**
  **60000, Bucharest (RO)**
• **Dumitru, Viorel Georgel**
  **100077, Prahova (RO)**

(74) Representative: **Buckley, Guy Julian**
**Patent Outsourcing Limited**
**1 King Street**
**Bakewell**
**Derbyshire DE45 1DZ (GB)**

(54) **Improved hole transfer polymer solar cell**

(57)     A solar cell comprisies a photovoltaic material and at least one polymer layer. In a further embodiment, a first polymer layer is electrically coupled to the photovoltaic material and has a high density of defects to facilitate hole transfer, and a second layer is electrically coupled to the first polymer layer and has a low density of defect states to facilitate hole transport. In another embodiment, a p-type polymer layer is electrically coupled to the photovoltaic material, and is configured to have a reduced lattice reorganization energy by modification of the polymer lattice

EP 2 256 762 A1

## Description

### Field of the Invention

The invention relates generally to electrical solar cells, and more specifically to improved hole transfer in a solar cell polymer.

### Background

Solar cells are devices that convert solar energy, or light, into electricity. They rely on an physical phenomenon known as the photovoltaic effect to perform the conversion, which occurs when a photon strikes a suitable material such as a photovoltaic semiconductor, causing an electron-hole pair to be freed from the material.

The light striking a surface has a characteristic energy per photon, based on the frequency of the light. If an electron in a material struck by a photon absorbs enough energy from the photon to overcome the work function, or electron binding energy, of the electron, the electron springs free and a free electron-hole pair is created in the photovoltaic material. The energy of the emitted electrons is therefore dependent on the frequency of the light striking the material, and the number of electrons emitted is dependent on the intensity of the light or the number of photons striking the surface.

Solar cells use this effect to convert light energy, or photons, into electricity, or free electrons. In a traditional solar cell, a material such as silicon is struck by photons, causing electrons to become free and create electricity by flowing in one direction through the cell due to the semiconductor junction configuration of the solar cell. More specifically, if a photon's energy is higher than the silicon material's band gap, or electron binding energy, an electron is freed and an electron-hole pair is created. Because traditional solar cells are formed using a p-n junction as in a diode, the generated electricity can flow only one way through the solar cell when the cell is attached to an electric circuit or load.

Although silicon was most common in early solar cells, newer high efficiency solar cells use other materials such as other semiconductors, polymers, and even light-absorbing dyes as photovoltaic material in an attempt to improve efficiency and reduce manufacturing cost or complexity. Although early solar cells were in the single-digit range for efficiency, modem cells can have efficiencies in the range of 30-40% under ideal conditions. Improvement in efficiency and reduction in cost means that more electricity can be generated with less investment in materials and in area consumed by the solar cells, making them an increasingly desirable means of electrical power generation.

### Summary

One example embodiment of the invention comprises a solar cell comprising a photovoltaic material and at least one polymer layer. In a further embodiment, a first polymer layer is electrically coupled to the photovoltaic material and has a high density of defects to facilitate hole transfer, and a second layer is electrically coupled to the first polymer layer and has a low density of defect states to facilitate hole transport. In another embodiment, a p-type polymer layer is electrically coupled to the photovoltaic material, and is configured to have a reduced lattice reorganization energy by modification of the polymer lattice

### Brief Description of the Figures

Figure 1 shows an example of hole transfer from a quantum dot photovoltaic material to a hole conducting polymer, consistent with an example embodiment of the invention.

Figure 2 illustrates energy levels of a quantum dot photovoltaic material and hole conducting polymer, along with intrinsic density of states in the hole conducting polymer relative to energy, consistent with some embodiments of the invention.

Figure 3 illustrates modification of the density of states in a hole conductor such as that of Figure 2, consistent with an example embodiment of the invention.

### Detailed Description

In the following detailed description of example embodiments of the invention, reference is made to specific example embodiments of the invention by way of drawings and illustrations. These examples are described in sufficient detail to enable those skilled in the art to practice the invention, and serve to illustrate how the invention may be applied to various purposes or embodiments. Other embodiments of the invention exist and are within the scope of the invention, and logical, mechanical, electrical, and other changes may be made without departing from the subject or scope of the present invention. Features or limitations of various embodiments of the invention described herein, however essential to the example embodiments in which they are incorporated, do not limit other embodiments of the invention or the invention as a whole, and any reference to the invention, its elements, operation, and application do not limit the invention as a whole but serve only to define these example embodiments. The following detailed description does not, therefore, limit the scope of the invention, which is defined only by the appended claims.

Solar cells convert light to electricity by using a material such as a semiconductor, polymer, or other suitable material that emits electrons when photons of suitable energy strike the material. When the photon strikes the solar cell material, an electron having an electron binding energy lower than the energy imparted by the photon becomes free, creating an electron/hole pair that can propagate through a conductive circuit, creating electricity if the electron-hole pair can be separated before they recombine. External circuits can be powered by the solar cell by coupling the circuit to the solar cell such as through metallic or polymer connections to the solar cell material, which in semiconductor solar cells typically includes a p-n junction that causes electricity to flow in only one direction. In other technologies, transport electrodes such as polymers carry electrons and holes from quantum dots or other photovoltaic materials to electric circuits.

In many solar cell structures, polymers are used as hole transport electrode, after the hole generation under the influence of light in the cromophore and the hole's transfer from the cromophore to the polymer. The cromophore is a part of the solar cell material where the molecular orbitals fall within the range of the visible spectrum of light, such that light striking the chromophore can be absorbed by exciting an electron from its ground state into an excited state. Such a structure can be, for instance, a dye or a quantum dot sensitized solar cell structure. In these cases, the dye and the dot play the role of the cromophore.

Hole transport in p-type polymers is dominated by electrons hopping between different energy states. This is possible in part through the thermal energy of the polymer lattice, such that lattice reorganization assists in hole conduction through the polymer. The lower the reorganization energy threshold, the more likely such lattice reorganization occurs and the higher the probability of transfer from one energy level to another, and therefore, the higher the hole mobility.

Because the reorganization energy of the polymer is determined by the lattice vibration modes specific to the polymer, there is a lower limit for reorganization energy determined by the atomic vibration mode with the lowest energy existing in the specific polymer. Some embodiments of the invention seek to in effect "tune" the energy levels participating in the hole hopping mechanism so as to be separated in energy by a given phonon mode or a combination of different vibration modes, thereby enhancing hole mobility in the polymer.

This can be achieved in one example by introducing energy levels in the polymer by methods such as doping, irradiation, ion implantation, etc. into the polymer lattice. The position of energy levels in the polymer lattice is monitored during this modification, and the differences between the different pairs of energy levels is determined and compared with the atomic vibration energy modes or phonons in the polymer, especially with those energy levels located in the lowest energy part of the polymer vibration spectrum. The dopants in a further embodiment are selected so that the energy difference between the two energy levels fits the energy of a given vibration mode, or a combination of different modes, of the polymer.

The polymer chain is characterized in part the by highest occupied molecular orbitals (HOMO) and lowest unoccupied molecular orbitals (LUMO), such that the band gap or energy difference between the highest occupied and lowest unoccupied molecular orbitals is the energy needed to excite the molecule and cause an electron to jump orbitals, permitting conduction. Short distance correlation along the electrode's polymer chain is a source of energy distribution around the Highest Occupied Molecular Orbitals (HOMO) of the polymer. Usually, the distribution of these energy states or Density of States (DOS) is a Gaussian distribution. Density of States describes the number of states available to be occupied at various energy levels for a given volume or unit of material.

Density of States can be manipulated using defects intentionally introduced into a hole conducting polymer as described above, and the role of the defect-induced DOS is important in both hole transfer and transport in polymer. For a higher hole transfer rate, a larger dispersion of these states is required, while the opposite is required for a higher mobility. Some embodiments of the invention propose solutions to this and other problems.

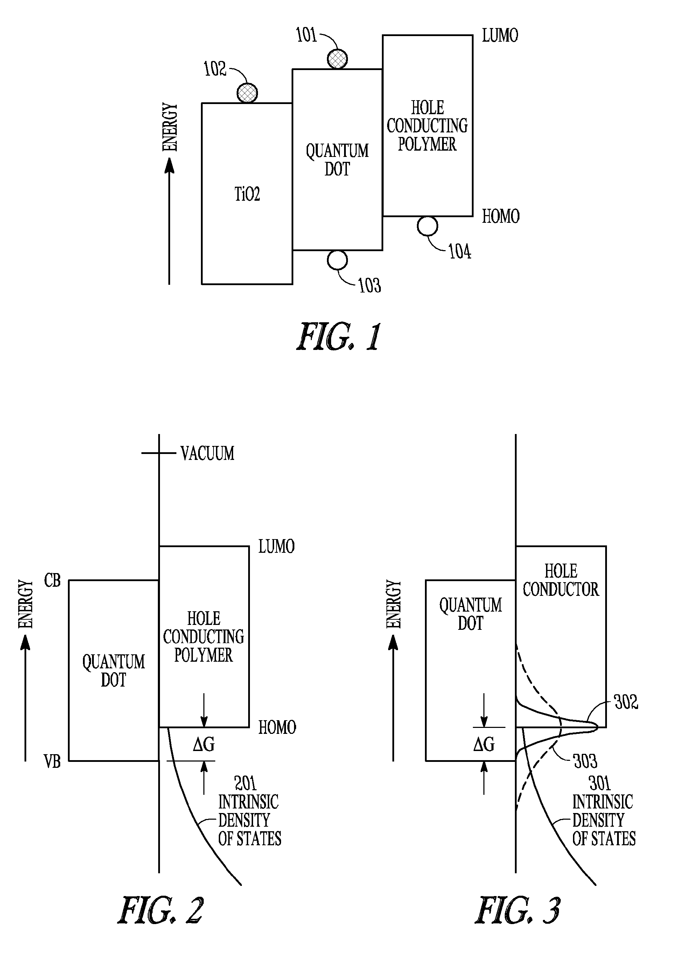

Figure 1 illustrates an example model for hole transfer between a quantum dot and a hole conductor, consistent with some example embodiments of the invention. First, an exciton (captive hole-electron pair) is generated in the quantum dot by photon absorption, creating an electron 101 that is transferred to the titanium dioxide $(TiO_2)$ electron conductor as shown at 102. The hole 103 is transferred from the quantum dot to the hole conducting polymer 104. This mechanism of charge separation captures the freed electron and hole created by the photovoltaic effect.

Here, we are concerned with the hole transfer at a quantum dot-polymer interface, as shown in Figure 2. The quantum dot's forbidden energy levels range between its valence band (VB) and conduction band (CB). The hole conducting polymer's energy levels facilitating hopping are close to the highest occupied molecular orbital (HOMO) level of the polymer. The difference between the quantum dot's valence band energy and the polymer's highest occupied molecular level is the band offset shown as delta-G, indicating the minimum energy needed to conduct a hole from the quantum dot to the polymer.

If a Gerischer model (Surface Science 18, 97, 1969) of hole transfer is assumed, the rate of hole transfer ($k_{HT}$) from quantum dot (QD) to the hole conductor is given by:

$$k_{HT} \int \sim k(G) \, D_{QD} \, D_P(G) \, dG \, , \qquad (1)$$

where k(G) is the so-called transfer frequency, $D_{QD}$ is the hole donor states in the quantum dot and $D_P(G)$ is the density of hole acceptor states in the p-type conductor (polymer). In other words, the $D_P(G)$ is the electron density of states in the valence band of the polymer. Usually, quantitative data on the density of states can be obtained by Ultraviolet and/or X-ray Photoelectron Spectroscopy (UPS/XPS).

Usually, the region of free energy (ΔG) at the QD-polymer interface of interest for the hole transfer is (much) below 1eV (ΔG<1eV). In this region, for most of the existing conjugated (conducting) polymers, the Density Of States (DOS) is almost independent of energy, as shown by the intrinsic density of states curve 201. Therefore, to a good approximation, the above relation can be written as:

$$k_{HT} \sim D_P(G) \int k(G) \, D_{QD} \, dG \ \text{ or } \qquad (2)$$

$$k_{HT} \sim D_P(G). \qquad (3)$$

Therefore, the polymer DOS is a measure of the rate of hole transfer. Consequently, a polymer with a high DOS in the valence band should be more favorable to hole transfer than a polymer with a low DOS.

Another factor affecting the hole transfer can be the disorder/defect-induced density of states around the polymer HOMO states. A semiconducting polymer is not a perfect conjugated system, because its twisted and kinked chains and chemical defects cause conjugation breaks. The energy disorder is ascribed to the different environment of each molecule: static and dynamic disorder in position and orientation affect the molecular energy levels through electrostatic and steric interactions. Consequently, an energetic (E) spread/distribution of the charge transport sites is present around the both HOMO and LUMO (Lowest Unoccupied Molecular Orbital) levels of the polymer (Figure 2). This distribution is often approximated in shape by a Gaussian Density Of States (DOS=g):

$$g = \frac{N_V}{\sqrt{2\pi} \cdot \sigma} \exp\left[ -\left( \frac{\varepsilon - \varepsilon_0}{\sqrt{2} \cdot \sigma} \right)^2 \right]$$

where σ is the distribution width (variance), $N_V$ is the total density of states and $E_0$ is the position of the peak.

The total density of states in polymer is given by the sum of the intrinsic and extrinsic density of states, as shown in Figure 3. Here, the intrinsic density of states 301 is illustrated, along with defect-induced density of states 302, centered around the highest occupied molecular orbital of the hole conductor. In a further example, a larger variance of defect-induced states is created as shown at 303, producing considerable overlap between the broandened defect-induced density of states 303 and intrinsic density of states 301. This overlap between the intrinsic DOS of the polymer with the extrinsic DOS can be favorable to the hole transfer from the QD to the polymer because the larger the overlap of the DOS at the QD/polymer interface, the higher the probability of the hole transfer. It appears that a high extrinsic DOS is favorable to the hole transfer because its extension into the polymer valence band increases the total density of states. This extension depends on the distribution width (σ).

However, a polymer with a high extrinsic or defect-induced density of states is not favorable to hole mobility in the polymer, which is degraded by the presence of a high number of defects. As previously discussed, after transfer of the hole to the p-type polymer the hole is transported by hopping between different energy states, which is possible with participation of the thermal energy from the polymer lattice which contributes to polymer lattice reorganization. The lower the reorganization energy, the higher the probability of transfer from one energy level to another, therefore, the higher the hole mobility.

To preserve the mobility in the polymer, a number of technical solutions are presented. In one embodiment, a single polymer layer is used but a higher density of defects is created (by irradiaton with different particles, for instance, or by any other method) in a very thin layer in the polymer at cromophore/polymer interface. Such a layer may include or be formed from polymers such as P3HT, or poly(3-hexyl thiophene), poly[3-(ω-mercapto hexyl)] thiophene, poly[3-(ω-mercapto undecyl)] thiophene, poly[3-(ω-mercapto dodecyl)] thiophene, MEH-PPV, or poly[2,5-dimethoxy-1,4-phenylene-1,2-ethenylene,2-methoxy-5-2-ethylhexyloxy-1,4-phenylene-1,2-ethylene), PPP, or poly(p-phenylene), TFB, or poly(9,9-dioctylfluorene-co-N-(4-(3-methylpropyl)-diphenylamine), and the like.

In another embodiment, a polymer layer of a few nanometers thick is used. After deposition, defects are induced in this layer by irradiation (X-ray or any other method). A second layer of the same polymer is deposited on the first one. This layer has to have a low density of defect states. This can be considered as a transport layer capable to allow for a higher mobility. Such layers may include or be formed from polymers such as P3HT, orpoly(3-hexyl thiophene), poly[3-(ω-mercapto hexyl)] thiophene, poly[3-(ω-mercapto undecyl)] thiophene, poly[3-(ω-mercapto dodecyl)] thiophene, MEH-PPV, or poly[2,5-dimethoxy-1,4-phenylene-1,2-ethenylene,2-methoxy-5-2-ethylhexyloxy-1,4-phenylene-1,2-ethylene), PPP, or poly(p-phenylene), TFB, or poly(9,9-dioctylfluorene-co-N-(4-(3-methylpropyl)-diphenylamine), and the like.

In another embodiment, olygomers of a given polymer are used as transfer layer, while the polymer is used as a transport layer. This can be especially advantageously when the electrode for the electron transport (e.g.: TiO2) has a mesoporous structure for the olygomer chain is wetting better the mesopores. Then, a second layer of the polymer is deposited. Such layers may include or be formed from polymers such as P3HT, or poly(3-hexyl thiophene), poly[3-(ω-mercapto hexyl)] thiophene, poly[3-(ω-mercapto undecyl)] thiophene, poly[3-(ω-mercapto dodecyl)] thiophene, MEH-PPV, or poly[2,5-dimethoxy-1,4-phenylene-1,2-ethenylene,2-methoxy-5-2-ethylhexyloxy-1,4-phenylene-1,2-ethylene), PPP, or poly(p-phenylene), TFB, or poly(9,9-dioctylfluorene-co-N-(4-(3-methylpropyl)-diphenylamine), and the like.

In another embodiment, a polymer (P3HT, for instance) may be used as a transfer layer, while the same polymer but in a regioregular state (P3HT, for instance) may be used as a transport layer, for in a regioregular state, the polymer exhibits higher hole mobility.

In another embodiment, two different polymers may be used. A polymer with a lower mobility may be used to realize the transfer layer, while a polymer with a higher mobility may be used as a transport layer.

In yet another embodiment, a polymer with a lower molecular weight may be used as a transfer layer, while another polymer may be used as a transport layer. olygomers of a given polymer are used as transfer layer, while the polymer is used as transport layer. In another embodiment, a first thin layer may be deposited

In another embodiment, a polymer may be used to realize the transfer layer, while small molecules can be used to realize the transport layer. In order for hole to be transported, it is necessary that the ionization potential of the small molecule to be lower than the ionization potential of the polymer. P3HT, or poly(3-hexyl thiophene), poly[3-(ω-mercapto hexyl)] thiophene, poly[3-(ω-mercapto undecyl)] thiophene, poly[3-(ω-mercapto dodecyl)] thiophene, MEH-PPV, or poly[2,5-dimethoxy-1,4-phenylene-1,2-ethenylene,2-methoxy-5-2-ethylhexyloxy-1,4-phenylene-1,2-ethylene), PPP, or poly(p-phenylene), TFB, or poly(9,9-dioctylfluorene-co-N-(4-(3-methylpropyl)-diphenylamine), P3-DDT, Poly(3-dodecylthiophene), MDMO-PPV Poly[2-methoxy-5-(3,7-dimethyloctyloxyd-phenylene vinylene] and the like may be used as polymer, while pentacene may be used as hole transporting molecule.

In another embodiment, a single hole conducting layer of a few nanometers width formed from small molecules may be used. Such a small molecule may be pentacene and the like. Another second layer of pentacene with a higher mobility may be deposited on the first one. Such a small organic molecular conductor with higher mobility can be obtained by purification of the material by vacuum sublimation, for instance.

In another embodiment, two different small molecule may be used. A small molecule with a low hole mobility may be used for the transfer layer, while another small molecule with a high hole mobility may be used as the transport layer. For instance, Spiro-OmeTAD may be used for the transfer layer (hole mobility of the order $10^{-4}$ cm$^2$/Vs), while pentacene may be used for the transport layer (hole mobility higher than 2 cm$^2$/Vs).

In an embodiment, a single small molecule layer is used but a higher density of defects is created (by irradiaton with different particles, for instance, or by any other method) in a very thin layer in the molecule layer at cromophore/molecule layer interface. Such a molecule may be pentacene and the like.

Although specific embodiments have been illustrated and described herein, it will be appreciated by those of ordinary skill in the art that any arrangement that achieve the same purpose, structure, or function may be substituted for the specific embodiments shown. This application is intended to cover any adaptations or variations of the example embodiments of the invention described herein. It is intended that this invention be limited only by the claims, and the full scope of equivalents thereof.

**Claims**

1.  A solar cell comprising:

    a photovoltaic material;
    a first polymer layer electrically coupled to the photovoltaic material, the first polymer layer having a high density of defects to facilitate hole transfer; and
    a second layer electrically coupled to the first polymer layer and having a low density of defect states to facilitate hole transport.

2.  The solar cell of claim 1, wherein the first polymer layer defect density is configured to facilitate hole transfer, and the second layer defect density is configured to increase hole transport.

3.  The solar cell of claim 1, wherein the second layer is a polymer.

4.  The solar cell of claim 3, wherein the second layer comprises a polymer with additional energy levels relative to the first polymer layer.

5.  The solar cell of claim 4, wherein the additional energy levels of the second layer comprise a reduction in lattice reorganization energy by modification of the polymer lattice to increase hole transport.

6.  The solar cell of claim 5, wherein modification of the polymer lattice of the second layer comprises at least one of doping, ion implanting, and irradiating the polymer.

7.  A solar cell comprising:

    a photovoltaic material;
    a p-type polymer layer electrically coupled to the photovoltaic material, the p-type polymer layer configured to have a reduced lattice reorganization energy by modification of the polymer lattice.

8.  The solar cell of claim 7, wherein modification of the polymer lattice comprises at least one of doping, ion implanting, and irradiating the polymer.

9.  The solar cell of claim 7, wherein the lattice reorganization energy of the polymer is configured to increase the hole mobility of the polymer layer.

10. A method of forming a solar cell, comprising:

    forming a photovoltaic material;
    forming a first polymer layer electrically coupled to the photovoltaic material, the first polymer layer having a high density of defects to facilitate hole transfer; and
    forming a second layer electrically coupled to the first polymer layer and having a low density of defect states to facilitate hole transport.

11. The method of forming solar cell of claim 1, wherein the first polymer layer defect density is configured to facilitate hole transfer, and the second layer defect density is configured to increase hole transport.

12. The method of forming solar cell of claim 1, wherein the second layer is a polymer.

13. The method of forming solar cell of claim 12, wherein the second layer comprises a polymer with additional energy levels relative to the first polymer layer.

14. The method of forming solar cell of claim 13, wherein the additional energy levels of the second layer comprise modification of the polymer lattice to increase hole transport by causing a reduction in lattice reorganization energy.

15. The method of forming solar cell of claim 14, wherein modification of the polymer lattice of the second layer comprises at least one of doping, ion implanting, and irradiating the polymer.

**16.** A method of forming a solar cell comprising:

forming a photovoltaic material; and
forming a p-type polymer layer electrically coupled to the photovoltaic material, the p-type polymer layer configured to have a reduced lattice reorganization energy by modification of the polymer lattice.

**17.** The solar cell of claim 16, wherein modification of the polymer lattice comprises at least one of doping, ion implanting, and irradiating the polymer.

**18.** The solar cell of claim 16, wherein the lattice reorganization energy of the polymer is configured to increase the hole mobility of the polymer layer.

FIG. 1

FIG. 2

FIG. 3

**EUROPEAN SEARCH REPORT**

Application Number

EP 09 16 1215

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2006/069751 A (UNIV MAINZ JOHANNES GUTENBERG [DE]; ZENTEL RUDOLF [DE]; ALLARD DIRK [D) 6 July 2006 (2006-07-06)<br>* page 7, line 15 - line 17 *<br>* page 8, line 9 - line 30 *<br>* page 15, line 22 - page 16, line 1 *<br>----- | 1-3,7,10-12,16 | INV.<br>H01G9/20<br>H01L51/44 |
| X | NAKAMURA JUN-ICHI ET AL: "Efficient organic solar cells by penetration of conjugated polymers into perylene pigments"<br>JOURNAL OF APPLIED PHYSICS, AMERICAN INSTITUTE OF PHYSICS. NEW YORK, US,<br>vol. 96, no. 11,<br>1 December 2004 (2004-12-01), pages 6878-6883, XP012068390<br>ISSN: 0021-8979<br>* page 6879, column 1, line 23 - column 2, line 10 *<br>* page 6880, column 2, line 21 - page 6881, column 1, line 16 *<br>* page 6880, column 1, line 4 - line 14 *<br>----- | 1-6,10-15 | |
| X | REYNAERT J ET AL: "PHOTOMULTIPLICATION IN DISORDERED UNIPOLAR ORGANIC MATERIALS"<br>ADVANCED FUNCTIONAL MATERIALS, WILEY VCH, WIENHEIM, DE,<br>vol. 16, no. 6, 4 April 2006 (2006-04-04), pages 784-790, XP001241970<br>ISSN: 1616-301X<br>* page 784, column 2, line 21 - line 25 *<br>* page 785, column 1, line 7 - column 2, line 3 *<br>* page 787, column 1, line 17 - line 42 *<br>* page 787; figure 1 *<br>----- | 7-9,16-18 | TECHNICAL FIELDS<br>SEARCHED (IPC)<br>H01G<br>H01L |

-/--

The present search report has been drawn up for all claims

| Place of search | Date of completion of the search | Examiner |
|---|---|---|
| Munich | 23 October 2009 | Pusch, Catharina |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

**EUROPEAN SEARCH REPORT**

Application Number

EP 09 16 1215

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PACIOS R ET AL: "EFFECTS OF PHOTO-OXIDATION ON THE PERFORMANCE OF POLY[2-METHOXY-5-(3',7'-DIMETHYLOCTYLOXY)-1,4-PHENYLENE VINYLENE]:[6,6]-PHENYL C61-BUTYRIC ACID METHYL ESTER SOLAR CELLS" 20 October 2006 (2006-10-20), ADVANCED FUNCTIONAL MATERIALS, WILEY VCH, WIENHEIM, DE, PAGE(S) 2117 - 2126, 2006 , XP001500481 ISSN: 1616-301X * page 2117, column 2, line 22 - line 27 * * page 2118, column 1, line 42 - column 2, line 13 * * page 2120, column 2, line 23 - line 27 * * page 2121, column 1, line 1 - line 4 * * page 2121, column 2, line 15 - line 19 * ----- | 1-6, 10-15 | |
| A | MATSUSHIMA T ET AL: "Enhancing hole transports and generating hole traps by doping organic hole-transport layers with p-type molecules of 2,3,5,6-tetrafluoro-7,7,8,8-tetracyanoquinodimethane" THIN SOLID FILMS, ELSEVIER-SEQUOIA S.A. LAUSANNE, CH, vol. 517, no. 2, 28 November 2008 (2008-11-28), pages 874-877, XP025625013 ISSN: 0040-6090 [retrieved on 2008-07-19] * page 876, column 1, line 1 - column 2, line 22 * ----- | 6,9,15, 17 | TECHNICAL FIELDS SEARCHED (IPC) |

The present search report has been drawn up for all claims

| Place of search | Date of completion of the search | Examiner |
|---|---|---|
| Munich | 23 October 2009 | Pusch, Catharina |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 09 16 1215

This annex lists the patent family members relating to the patent documents cited in the above-mentioned European search report.
The members are as contained in the European Patent Office EDP file on
The European Patent Office is in no way liable for these particulars which are merely given for the purpose of information.

23-10-2009

| Patent document cited in search report | Publication date | Patent family member(s) | Publication date |
|---|---|---|---|
| WO 2006069751    A | 06-07-2006 | DE 102004063030 A1<br>EP      1834343 A1 | 17-08-2006<br>19-09-2007 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- *Surface Science,* 1969, vol. 18, 97